# EUROPEAN PATENT SPECIFICATION

(11) **EP 1 542 497 B1**
(45) Date of publication and mention of the grant of the patent: **02.11.2011**
(21) Application number: 03794270.3
(22) Date of filing: 05.09.2003
(51) Int. Cl.: H04R 9/02, H04R 1/22, H04R 1/28

(54) **LOUDSPEAKER WITH VIBRATING FUNCTION FOR A PORTABLE TERMINAL**
LAUTSPRECHER MIT VIBRATIONSFUNKTION FÜR EIN TRAGBARES ENDGERÄT
HAUT-PARLEUR AVEC FONCTION DE VIBRATION POUR UN TERMINAL PORTABLE

(30) Priority: 06.09.2002 JP 2002261090
(43) Date of publication of application: 15.06.2005
(73) Proprietor: NAMIKI SEIMITSU HOUSEKI KABUSHIKI KAISHA, Tokyo 123-8511 (JP)
(72) Inventor: KANEDA, Shoichi, Adachi-ku, Tokyo 123-8511 (JP); KUMAGAI, Takayuki, Adachi-ku, Tokyo 123-8511 (JP); HASHIMOTO, Yuichi, Adachi-ku, Tokyo 123-8511 (JP)
(74) Representative: Prinz & Partner
(86) International application number: PCT/JP2003/011393
(87) International publication number: WO 2004/023843

(56) References cited:
- WO-A-01/41496
- CA-A1- 2 270 726
- JP-A- 9 130 889
- JP-A- 11 007 285
- JP-A- 58 218 296
- JP-A- 2000 325 879
- JP-A- 2002 219 410
- US-A- 4 931 765

## Description

### TECHNICAL FIELD

The present invention relates a device for notification of incoming calls, to be mounted in portable terminal equipment. Particularly, it relates to a multi-function vibrating actuator device that has the function of generating a vibration producing a bodily sensation, and the function of generating a ring tone; it principally relates to a multi-function vibrating actuator device with improved bodily-sensible vibration characteristics.

### BACKGROUND ART

Multi-function vibrating actuator devices (referred to hereafter simply as "devices" as necessary) that generate both a bodily-sensible vibration and a ring tone in a single device are generally known, as means of notification of incoming calls in terminal equipment represented by portable telephones.

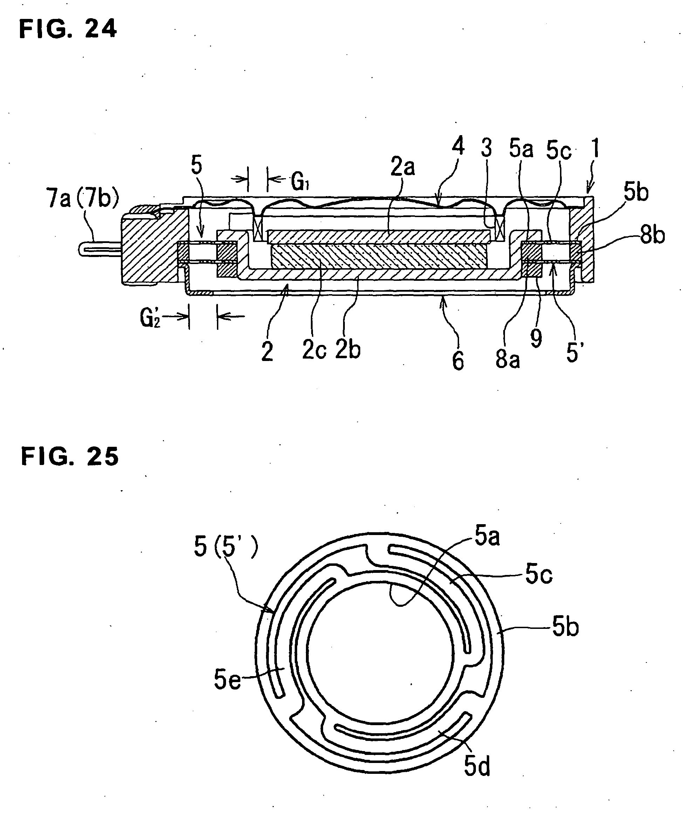

This sort of multi-function vibrating actuator device, as exemplified by the inner-magnet type shown in FIG. **24****,** comprises a housing **1** that is substantially cylindrical and open at both ends, a magnetic circuit **2** that includes a pole piece **2a** and a yoke **2b** fastened to a magnet **2c** and separated by a gap **G1** that functions as the magnetic gap, a diaphragm **4** that is fastened atop a voice coil **3,** and suspensions **5, 5'** that supports the magnetic circuit **2.**

Within this device, the diaphragm **4** is mounted so as to cover one open end of the housing **1,** such that the voice coil **3** is located within the magnetic gap **G1** and the edge of the diaphragm **4** is fixed within one open end of the housing **1.** The opening at the other end of the housing **1** is covered by a ring-shaped cover **6** that is fitted into the other open end of the housing **1.** The voice coil **3** is electrically connected to terminal fittings **7a (7b)** mounted on the outside of the housing **1** by lead wires that run from the diaphragm **4** to the outside of the housing **1.**

The suspensions **5, (5'),** as shown in FIG. **25** (both are the same shape, so only one suspension is shown), comprise a supporter **5a** that is fixed to and supports the magnetic circuit, an outer ring **5b** that is mounted inside the housing **1,** and three spring arms **5c** through **5e** that are located at equal distances (separated by 120° in the example shown) and extend in the same direction from the outer edge of the supporter **5a** (circumferential, in the example shown) to connect the supporter **5a** and the outer ring **5b** (see, for example, Patent Document 1).

The suspensions **5, 5'** are mounted by fitting them inside the housing **1** so that the supporter **5a** supports the magnetic circuit **2.** In greater detail, spacer rings **8a, 8b** are located in the spaces between the supporters **5a** and the outer rings **5b** of the suspensions **5, 5',** and the supporter **5a** that is fitted to the outside of the yoke **2b** is held in place by a stopper ring 9; the outer ring **5b** is held in place by the cover **6.** In this way the magnetic circuit **2** is assembled so that it is supported and able to vibrate by flexing the spring arms **5c** through **5e**.

This multi-function vibrating actuator device is mounted in portable terminal equipment, and when a communication signal is received from elsewhere, a low-frequency electrical signal is impressed on the voice coil **3** and, by means of the electromagnetic action in the vicinity of the magnetic gap **G1**, the magnetic circuit **2** vibrates and that vibration is transmitted outwards. The user of the terminal equipment is made aware of the vibration as a bodily-sensible vibration, and the user is thus notified of the incoming call. On the other hand, if the incoming call causes a high frequency electrical signal to be impressed on the voice coil **3,** the electromagnetic action in the vicinity of the same magnetic gap **G1** causes the diaphragm **4** to vibrate and that vibration generates a ring tone or other sound, and the user is thus notified of the incoming call.

In conventional multi-function vibrating actuator devices, a large clearance **G2'** is maintained between the inner surface of the housing **1** and the outer surface of the yoke **2b** in order to allow the flexing of the spring arms **5c** through **5e**. Accordingly, together with the vibration of the magnetic circuit **2,** the air within the device moves freely within the device through the clearance **G2,** and so there is almost no resistance from the internal air to the vibration characteristics of the magnetic circuit **2.** Therefore, the vibration of the magnetic circuit **2** quickly starts up at resonant frequencies, and the bodily-sensible vibration characteristics are limited to a narrow frequency range that yields the desired vibration acceleration.

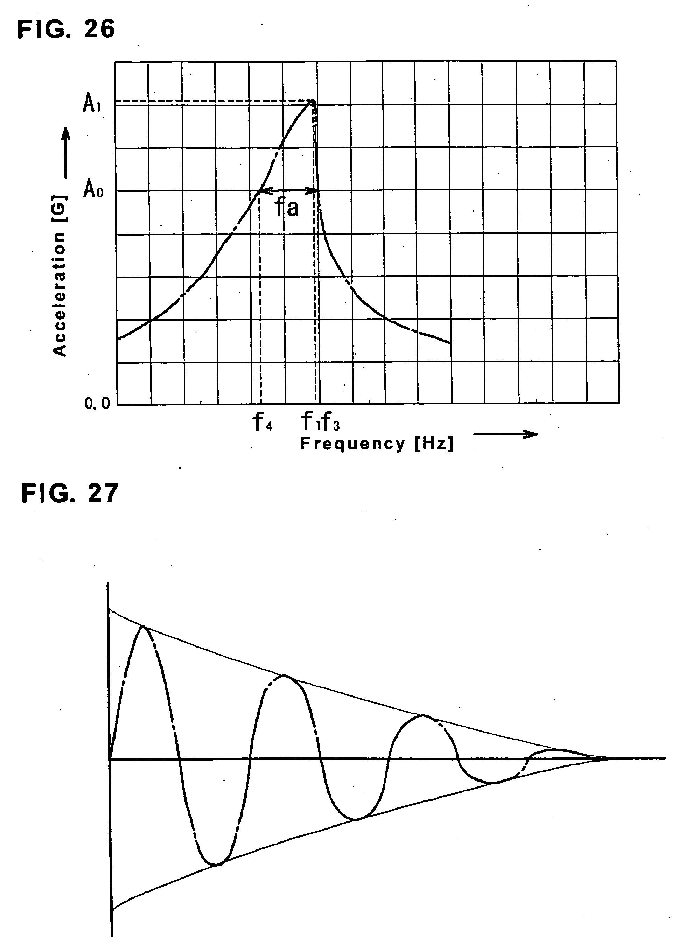

For example, when the acceleration necessary for bodily-sensible vibration is at least A0 [G] as shown in FIG. **26****,** the range of frequencies at which that acceleration can be obtained is the narrow frequency range fa [Hz]. And as the maximum acceleration A1 [G] is approached, there is maximum bodily-sensible vibration at that point, or in other words it is a point of resonance, but as soon as the frequency reaches or exceeds f1 [Hz], the acceleration falls sharply, and above f3 [Hz] the acceleration falls below A0 [G] and the necessary acceleration is unavailable.

In the frequency range below f1 [Hz], on the other hand, the drop in acceleration is comparatively less steep, but there is still a drop, and at frequencies less than f4 [Hz] the acceleration is less than A0 [G]. Therefore, if the frequency varies even slightly from the point of resonance, there will be a sharp drop in the amount of bodily-sensible vibration.

For that reason, in the event that the manufacturing process causes a scattering of vibration characteristics from one device to the next, or that there are variations in the environment of use of the terminal equipment in which the devices are mounted, it will be difficult to set the point of resonance and the frequency range within which the desired vibration acceleration can be obtained will be narrow, as described above, and so the point of resonance can easily fall outside that frequency range.

Further, when there is a blow to the outer case of the portable terminal equipment in which the multi-function vibrating actuator device is mounted, the vibration is conveyed to the multi-function vibrating actuator device, and the magnetic circuit vibrates. In conventional multi-function vibrating actuator devices, the magnetic circuit is supported by suspensions having the structure described above, and so the vibration characteristics of the magnetic circuit, as measured through the outer case, follow the curve shown in FIG. **27****.** The vertical axis of FIG. **27** indicates the amplitude of vibration of the magnetic circuit, and the horizontal axis shows the passage of time.

According to these vibration characteristics, if vibration is conveyed to the device when the portable terminal equipment in which the multi-function vibrating actuator device is mounted is awaiting an incoming call, or in other words, when the multi-function vibrating actuator device is not in operation, the magnetic circuit will vibrate for some time and cause vibration of the air, which will produce a strange noise like a plucked bowstring.

Generic WO 01/41496 A2 shows vibration actuator having a magnetic circuit of the internal magnet-type with a yoke and a disk-shaped permanent magnet which are coupled with one another. A housing is provided that is open on both ends thereof. A vibrating member and a coil fixed to the vibration member are provided in a magnetic gap of the magnetic circuit. The magnetic circuit is elastically suspended by a suspension plate and an additional elastic member is interposed between the suspension plate and the magnetic circuit to achieve a wide frequency band.

[Patent Document 1] Japanese Patent Laid-Open Publication No. 2002-1215

### DISCLOSURE OF THE INVENTION

The inventors of the present invention ascertained, as a result of diligent development, that using the air within the device as a damper is effective in terms of improving the stability of the vibration characteristics of the magnetic circuit. A primary object of the present invention is to adjust the size of the clearance between the inner surface of the housing and the outer surface of the magnetic circuit and thereby control the movement of the interior air in the space formed by the diaphragm and the magnetic circuit and the movement and the interior air in the space formed by the magnetic circuit and the cover, as well as improve the stability and utility of the vibration characteristics.

In addition, terminal equipment for portable use generally has performance and specifications that vary with each manufacturer, and so the individual parts mounted in that terminal equipment have performance and specifications that differ according to the demands of each manufacturer. Accordingly, an auxiliary object of the present invention is to adjust the size of the clearance between the inner surface of the housing and the outer surface of the magnetic circuit and thereby adjust and limit the movement of interior air within the device, as well as to enable easy realization of bodily-sensible vibration characteristics that meet the demands of each manufacturer.

Further, there is the object of adjusting and limiting the size of the clearance between the inner surface of the housing and the outer surface of the magnetic circuit and thereby, in combination with other methods, adjusting and limiting the movement of air between the space formed by the diaphragm and the magnetic circuit and the space formed by the magnetic circuit and the cover, and so achieve the stability and utility of the vibration characteristics.

Moreover, another object of the present invention is to constitute the device to enable reduction of the occurrence of the strange noise, like a plucked bowstring, caused by vibration of the magnetic circuit if the outer case of the portable terminal equipment in which the multi-function vibrating actuator device is mounted is awaiting an incoming call.
These objects are met by the features of claims 1 and 4.

Issues other than the objects stated above, along with concrete features, should become apparent in the course of explanations based on embodiments of the present invention.

In a multi-function vibrating actuator device, an outer-magnet type of magnetic circuit is provided, an air passage hole is formed at least at one part among the housing, cover and diaphragm, the magnetic circuit including the yoke, yoke palate and magnet is assembled with an outer surface thereof in close proximity to an inner surface of the housing so as to create a clearance between an outer surface of the magnetic circuit and an inner surface of the housing that measures more than 0% and not more than 2.5% of the inside radius of the housing, and the amount of movement of interior air in a space formed by the diaphragm and the magnetic circuit and of interior air in a space formed by the magnetic circuit and the cover is restricted by the clearance so as to expand a range of frequencies at which the magnetic circuit is able to vibrate.

In a multi-function vibrating actuator device, the yoke plate includes a ring with brim projections at an outer periphery of the ring in accordance with the number of spring arms, the brim projections being arranged so as not to overlap points of attachment between the housing and suspension.

In a multi-function vibrating actuator device, a through hole is formed in the magnetic circuit.

In a multi-function vibrating actuator device, an air passage hole is formed at least at one part among the housing, cover and diaphragm, a ring is fitted around an outer periphery of the magnetic circuit so as to create a clearance between an outer surface of the ring and an inner surface of the housing that measures more than 0% and not more than 2.5% of the inside radius of the housing, and the amount of movement of interior air in a space formed by the diaphragm and the magnetic circuit and of interior air in a space formed by the magnetic circuit and the cover is restricted by the clearance so as to expand a range of frequencies at which the magnetic circuit is able to vibrate.

In a multi-function vibrating actuator device, an inner-magnet type of magnetic circuit is provided, an air passage hole is formed at least at one part among said housing, cover and diaphragm, said magnetic circuit is assembled with an outer surface thereof in close proximity to an inner surface of the housing so as to create a clearance between an outer surface of the magnetic circuit and an inner surface of the housing that measures more than 0% and not more than 2.5% of the inside radius of the housing, and the amount of movement of interior air in a space formed by said diaphragm and said magnetic circuit and of interior air in a space formed by said magnetic circuit and said cover is restricted by said clearance so as to expand a range of frequencies at which said magnetic circuit is able to vibrate.

In a multi-function vibrating actuator device, there are provided a magnetic circuit forming a magnetic path, a suspension supporting the magnetic circuit, a diaphragm being placed facing the magnetic circuit, a voice coil being inserted into a magnetic gap formed in the magnetic circuit, and a housing enclosing the magnetic circuit, and the magnetic circuit is placed so as to create a clearance between an outer surface of the magnetic circuit and an inner surface of the housing and this clearance restricts the amount of air movement that measures more than 0 mm and not more than 0.2 mm.

In a multi-function vibrating actuator device, there are provided a movable part including a magnetic circuit that forms a magnetic path and a brim that extends in a radial direction of the magnetic circuit, a suspension supporting the movable part, a diaphragm being placed facing the movable part, a voice coil being inserted into a magnetic gap formed in the magnetic circuit, and a housing enclosing the movable part, and the movable part is placed so as to create a clearance between an outer surface of the movable part and an inner surface of the housing and this clearance restricts the amount of air movement that measures more than 0 mm and not more than 0.2 mm.

In a vibrating actuator device, there are provided a magnetic circuit forming a magnetic path, a suspension supporting the magnetic circuit, a voice coil being inserted into a magnetic gap formed in the magnetic circuit, and a housing enclosing the magnetic circuit, and the magnetic circuit is placed so as to create a clearance between an outer surface of the magnetic circuit and an inner surface of the housing and this clearance restricts the amount of air movement that measures more than 0 mm and not more than 0.2 mm.

In a vibrating actuator device, there are provided a movable part including a magnetic circuit that forms a magnetic path and a brim that extends in a radial direction of the magnetic circuit, a suspension supporting the movable part, a voice coil being inserted into a magnetic gap formed in the magnetic circuit, and a housing enclosing the movable part, and the movable part is placed so as to create a clearance between an outer surface of the movable part and an inner surface of the housing and this clearance restricts the amount of air movement that measures more than 0 mm and not more than 0.2 mm.

### BRIEF DESCRIPTION OF DRAWINGS

FIG. **1** is an exploded perspective view showing constituent parts of the multi-function vibrating actuator device of the present invention.

FIG. **2** is a cross section view showing the magnetic circuit to be assembled into the multi-function vibrating actuator device of FIG. **1****.**

FIG. **3** is an exploded perspective view showing the suspension and yoke plate to be assembled into the multi-function vibrating actuator device of FIG. **1****.**

FIG. **4** is a perspective view showing the assembled suspension and yoke plate of FIG. **3****.**

FIG. **5** is a side view showing, in the flexed state, the suspension spring arm in the assembled state of FIG. **4****.**

FIG. **6** is a cross section view showing the multi-function vibrating actuator device according to the first embodiment of the present invention.

FIG. **7** is an explanatory diagram showing the operation of the multi-function vibrating actuator device of FIG. **6** at the top dead center.

FIG. **8** is an explanatory diagram showing the operation of the multi-function vibrating actuator device of FIG. **6** at the bottom dead center.

FIG. **9** is a properties graph that shows a comparison of the vibration characteristics of the multi-function vibrating actuator device of the present invention and a conventional multi-function vibrating actuator device.

FIG. **10** is a properties graph that shows the relationship between the clearance of the multi-function vibrating actuator device of the present invention and its vibration characteristics.

FIG. **11** is a cross section view showing the multi-function vibrating actuator device according to the second embodiment of the present invention.

FIG. **12** is an exploded perspective view of the yoke, magnet and ring to be assembled in the multi-function vibrating actuator device of FIG. **11****.**

FIG. **13** is a cross section view showing the multi-function vibrating actuator device according to the third embodiment of the present invention.

FIG. **14** is a properties graph that shows changes in the vibration characteristics of the multi-function vibrating actuator device in accordance with the number of through holes made in the yoke of FIG. **13****.**

FIG. **15** is a curve diagram that shows the vibration characteristics of the magnetic circuit, as measured through the outer case of the portable terminal equipment in which the multi-function vibrating actuator device of the present invention is mounted, in comparison with a conventional multi-function vibrating actuator device.

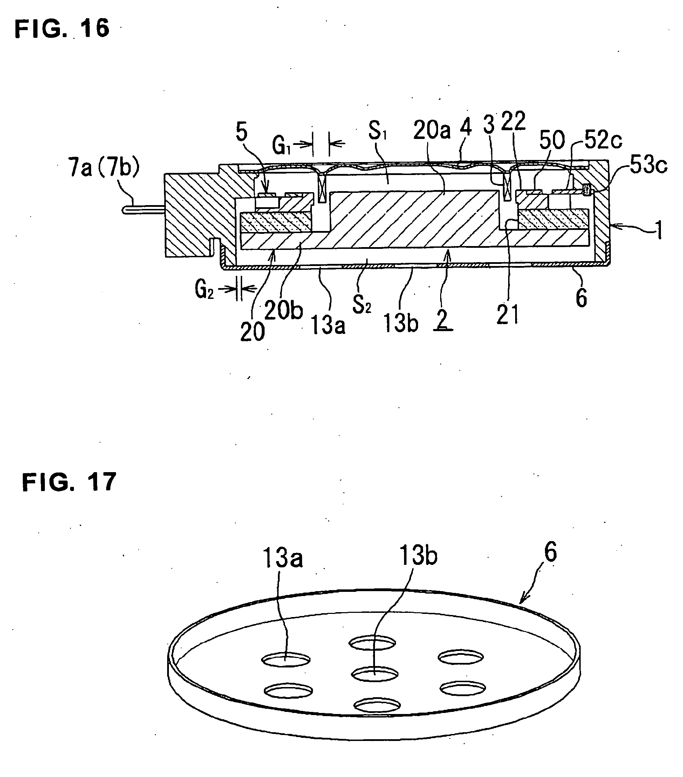

FIG. 16 is a cross section view showing the multi-function vibrating actuator device according to another embodiment of the present invention.

FIG. **17** is a cross section view showing the altered form of the cover used in the multi-function vibrating actuator device of the present invention.

FIG. **18** is a cross section view showing another altered form of the assembled constitution used in the multi-function vibrating actuator device of the present invention.

FIG. **19** is a cross section view showing an altered form of the magnetic circuit and yet another altered form of the assembled constitution used in the multi-function vibrating actuator device of the present invention.

FIG. **20** is a cross section view showing an altered form in which a ring is fitted to the magnetic circuit of FIG. **19****.**

FIG. **21** is a cross section view showing yet another altered form of the magnetic circuit used in the multi-function vibrating actuator device of FIG. **19****.**

FIG. **22** is a cross section view showing the inner magnet type of multi-function vibrating actuator device of the present invention.

FIG. **23** is an exploded perspective view showing the yoke to be assembled in the multi-function vibrating actuator device of FIG. **22****.**

FIG. **24** is a cross section view showing a conventional multi-function vibrating actuator device.

FIG. **25** is a plane view showing an example of the suspension assembled in the conventional multi-function vibrating actuator device.

Fig. **26** is a properties graph that shows the vibration characteristics of the conventional multi-function vibrating actuator device.

FIG. **27** is a curve diagram that shows the vibration characteristics of the magnetic circuit, as measured through the outer case of the portable terminal equipment in which the conventional multi-function vibrating actuator device is mounted.

Fig. 28 is a diagram that explains the rise characteristics of the multi-function vibrating actuator device of the present invention.

FIG. **29** is a cross section view showing the double suspension type of multi-function vibrating actuator device of the present invention.

FIG. **30** is a cross section view showing the vibrating actuator device of the present invention.

### BEST MODE FOR CARRYING OUT THE INVENTION

The illustrated embodiments that follow are primarily multi-function vibrating actuator devices of the outer-magnet type. Within their constitution there are many constituent parts in common with the conventional actuator, and a duplicative explanation of those parts has been omitted. Now, for convenience of description, the device as a whole is described with the diaphragm side as "up" and the cover side as "down."

<Basic Structure of the Device as a Whole>

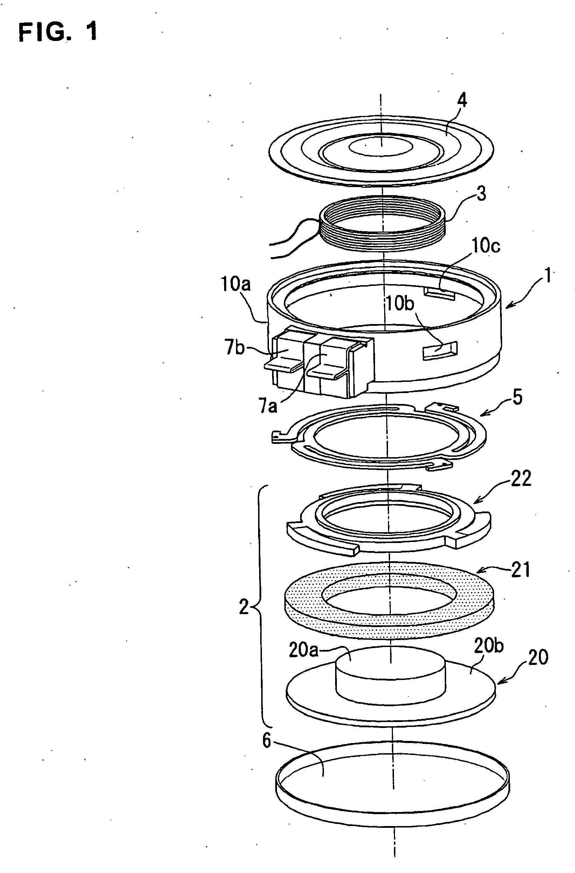

FIGS. **1** through **5** show the basic structure of the multi-function vibrating actuator device of the present invention as a whole. In this basic structure, as shown in FIG. **1****,** there is provided an outer-magnet type magnetic circuit that comprises a yoke **20** that includes a pole piece **20a** in the center of a round plate **20b,** a ring magnet **21,** and a substantially ring-shaped yoke plate **22** fastened together as a unit. The device as a whole also comprises a substantially cylindrical housing **1** that is open at both ends, a diaphragm **4** fastened to the top of a voice coil **3,** one suspension **5,** and a cover **6.**

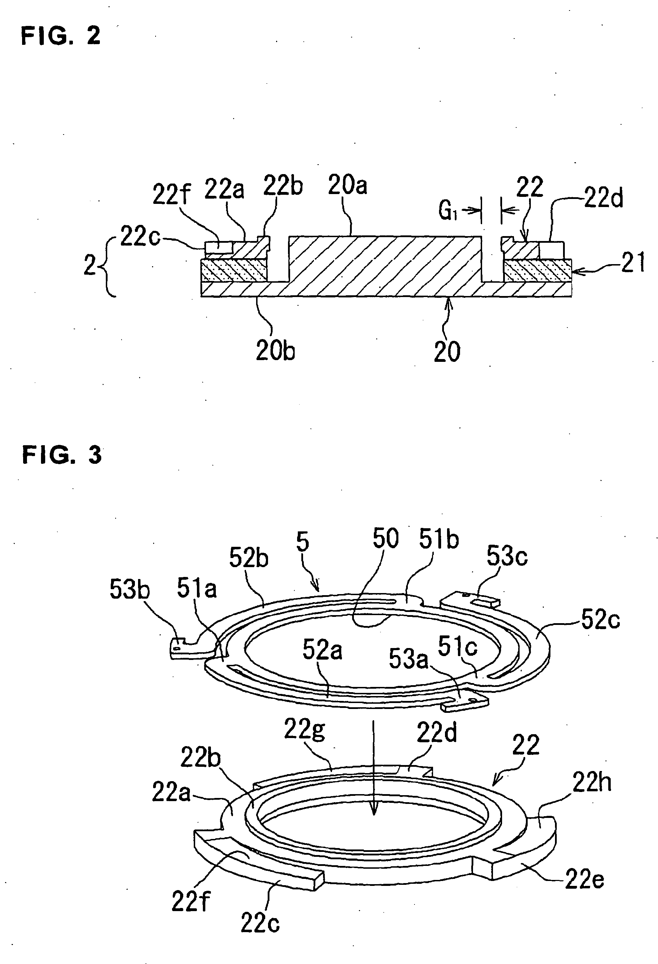

The magnetic circuit **2,** as shown in FIG. **2****,** includes the pole piece **20a** within the inside diameter of the magnet **21** and the yoke plate **22,** and the gap **G1** that functions as a magnetic gap is the gap between the outer surface of the pole piece **20a** and the inner surfaces of the magnet **21** and the yoke plate **22.** The three pieces-the yoke **20,** the yoke plate **22,** and the magnet **21** in the center-are fastened together as a single unit of the outer-magnet type.

The suspension **5,** as shown in FIG. **3****,** comprises a circular supporter **50,** which is fixed to and supports the magnetic circuit **2,** and three spring arms **52a** through **52c** that extend in the same direction from root points **51a** through **51c** located at equal distances with a 120° separation, following the shape of the supporter **50.** At the tips of the spring arms **52a** through **52c** there are attachment blades **53a** through **53c** for attachment to the housing **1.**

The yoke plate **22,** as shown in FIG. **3****,** is made up primarily of a ring **22a** with a retaining ring **22b** that holds the supporter **50** running along the inner circumference. On the outside surface of the ring **22a** there are three brim projections **22c** through **22e,** in accordance with the number of spring arms, located at equal distances with a 120° separation in order to effectively guide the magnetic flux from the magnet **21** in the magnetic gap **G1.**

The location and circumferential length of these brim projections **22c** through **22e** should be set not to overlap the attachment blades **53a** through **53c,** so that they will not contact the attachment blades **53a** through **53c** when the magnetic circuit **2** vibrates upward to top dead center. Moreover, the brim projections **22c** through **22e** have tapers **22f** through **22h** that slope down from the root points **51a** through **51c** toward the attachment blades **53a** through **53c,** in order to avoid contact with the spring arms **52a** through **52c** when the magnetic circuit **2** vibrates upward.

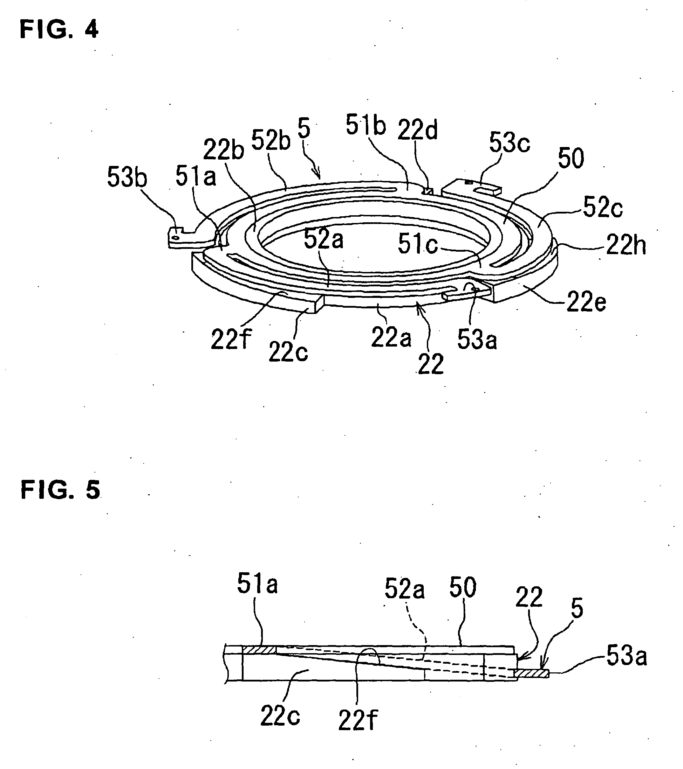

The suspension **5,** as shown in FIG. **4****,** has the supporter **50** for the magnetic circuit **2** fitted to the retaining ring **22b** of the yoke plate **22** and positioned on the upper surface of the ring **22a.** It is assembled and fixed to the yoke plate **22** with the root points **51a** through **51c** over the non-tapered surface of the brim projections **22c** through **22e,** the spring arms **52a** through **52c** over the tapers **22f** through **22h,** and the attachment blades **53a** through **53c** close to the edges of the brim projections **22c** through **22e.**

By means of this constitution, as shown in FIG. **5****,** the spring arms **52a** through **52c** are permitted to flex and deflect above the tapers **22f** through **22h,** and so the magnetic circuit **2** is formed with the yoke plate **22** mounted in relation to the magnetic circuit **2** in such a way that it can vibrate greatly before reaching top dead center.

The suspension **5** has the attachment blades **53a** through **53c** of the spring arms **52a** through **52c** attached to the sides of the housing **1,** and so supports the magnetic circuit **2** within the housing **1.** The diaphragm **4** is positioned with the voice coil **3** inside the magnetic gap **G1,** and its outer edge is fastened to the rim of the opening of the housing **1,** thus covering one end of the housing **1.** The cover **6** is assembled to cover the other open end of the housing **1,** with its outer edge fitted to the rim of the other open end of the housing **1.**

<Overview of Embodiments>

Three illustrated embodiments are presented under this basic structure. The first embodiment has air passage holes in the housing, and a clearance formed between the outer surface of the magnetic circuit and the inner surface of the housing. The second embodiment has a clearance formed by varying the amount of projection from the outer surface of the magnetic circuit. The third embodiment has through holes in the magnetic circuit in addition to air passage holes in the housing.

In each of these embodiments, the measurement of the clearance is set at more than 0 mm and not more than 0.2 mm, preferably at least 0.05 mm and not more than 0.15 mm, in order to keep the clearance in a range between 0% and 2.5% of the inside radius of the housing. By this means, vibration of the magnetic circuit within a narrow clearance is permitted, and the amount of movement of the interior air in the space formed by the diaphragm and the magnetic circuit and of the interior air in the space formed by the magnetic circuit and the cover is restricted by the clearance, by which means it is possible to expand the range of frequencies at which the magnetic circuit is able to vibrate.

<First Embodiment>

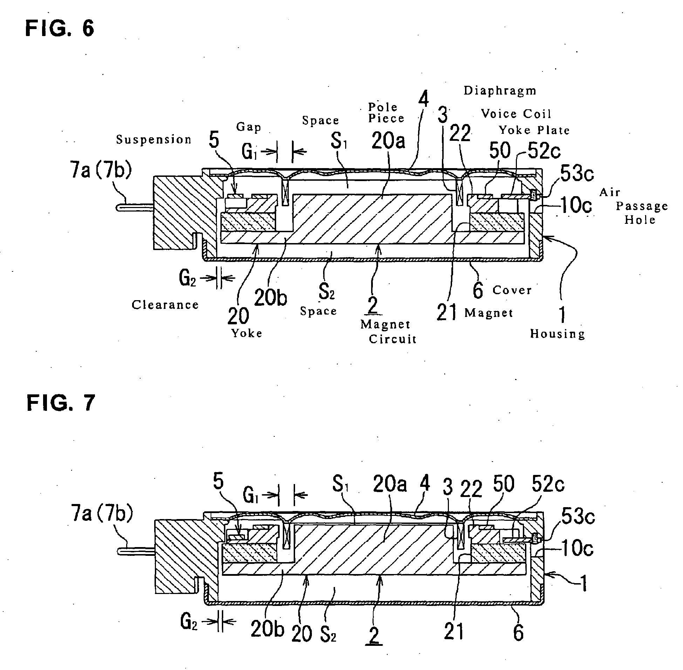

In the first embodiment, as shown in FIGS. **1** and **6****,** a number of air passage holes **10a** through **10c** have been opened in the side of the housing **1.** Further the outer surface of the round plate **20b** of the yoke **20** has been made to closely approach the inner surface of the housing **1,** and so a clearance **G2** is formed between the outer surface of the yoke and the inner surface of the housing. This limits the amount of reciprocal movement of the interior air in the space **S1** formed by the diaphragm **4** and the magnetic circuit **2** and the interior air in the space **S2** formed by the magnetic circuit **2** and the cover **6.**

In this embodiment there are, in the side of the housing **1,** three air passage holes (see **10a** through **10c** in FIG. **1**) to match the number of spring arms **52a** through **52c** of the suspension **5;** these air passage holes are also used for attachment of the attachment blades (see **53a** through **53c** in FIG. 3) on the spring arms (see **10c** and **53c** of FIG. **6**)**.** By this means, the suspension **5** is installed within the housing. Further, this allows an air-tight structure for the diaphragm **4** and the cover **6.**

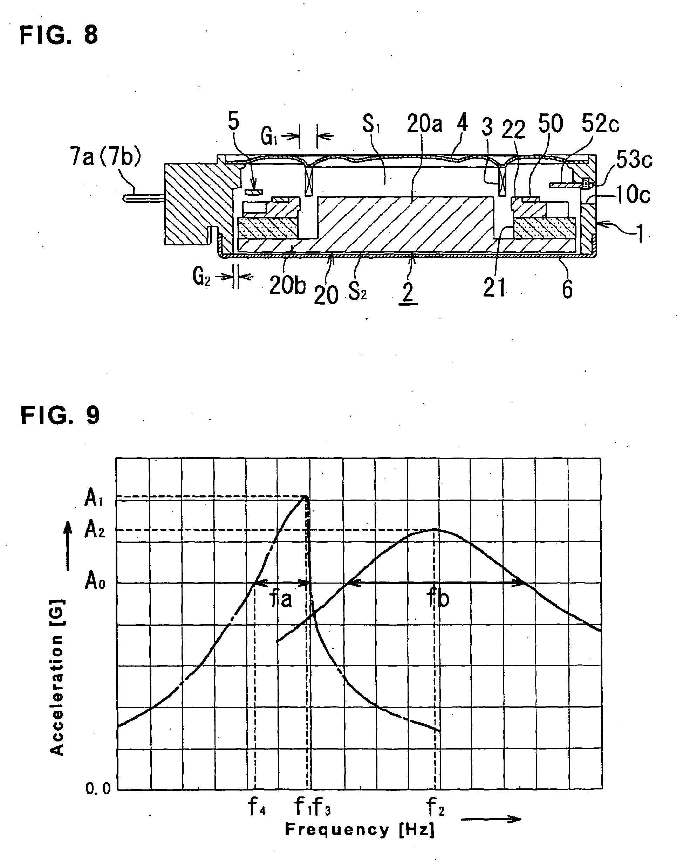

As shown in FIGS. **7** and **8****,** when an electrical signal of at least 100 Hz and not more than 200 Hz-preferably between 120 and 160 Hz-is impressed on the voice coil **3,** the electromagnetic operation of the magnetic circuit **2** and the voice coil **3** in the vicinity of the magnetic gap causes the magnetic circuit **2** to vibrate up and down within the housing **1,** flexing the spring arms **52a** through **52c** while maintaining the magnetic gap **G1.** When the magnetic circuit **2** vibrates up and down, the motion is transferred to the air within the device-that is, to the interior air in the space **S1** formed by the diaphragm **4** and the magnetic circuit **2** and the interior air in the space **S2** formed by the magnetic circuit **2** and the cover **6-**and that air also moves up and down.

Regarding the air as a fluid, the air that moves up and down in the two spaces **S1, S2** passes back and forth between the space **S1** and the space **S2** through the clearance **G2.** This clearance **G2** is made as narrow as possible by having the outer surface of the yoke **3** approach the inner surface of the housing **1** to a measurement in a range greater than 0% but not more than 2.5% of the inside radius R of the housing **1;** that is, in a range greater than 0 mm and not more than 0.2 mm, and preferably at least 0.05 mm and not more than 0.15 mm. Consequently, the interior air in the spaces **S1, S2** applies air pressure created by the up and down fluid motion to the small clearance **G2.** Because it is difficult for air to pass through the small clearance **G2** with this additional air pressure, the result is to limit the movement of the air in the spaces **S1, S2** between the two spaces.

Because the air thus restricted tends to remain in its respective space **S1, S2,** that residual air functions as a damper to restrain the up and down vibration of the magnetic circuit **2.** Accordingly, the amplitude of the up and down vibration of the magnetic circuit **2** is controlled, and so there is reduced variation in acceleration relative to variation in frequency, as shown by the solid curve in FIG. **9****,** yielding vibration characteristics with gentle slopes. These vibration characteristics display the following results.

First, this embodiment yields the acceleration required for bodily-sensible vibrations over a wide range of frequencies. If the acceleration required for bodily-sensible vibrations is set at A0 [G] and above, the frequency range within which such acceleration is achieved with the conventional actuator shown in FIG. **24** is the frequency range fa [Hz] shown by long-and-short dash curve in FIG. **9****.** In contrast, the present invention clearly widens that range to range fb [Hz] as shown by the solid curve in FIG. **9****.** Accordingly, it is difficult for the point of resonance to drift from that frequency range, and so the point of resonance is easily determined. Therefore, the desired vibration acceleration is easily attained, and the stability and utility of bodily-sensible vibration characteristics can be improved.

Second, there is less fall-off in the amount of bodily-sensible vibration. With the present invention, the maximum acceleration A2 [G] is obtained in the vicinity of the frequency f2 [Hz], as shown by the solid curve in FIG. **9****.** Since A1 [G] > A2 [G], the maximum acceleration is reduced, but compared with the conventional actuator, the drop in acceleration can be slight relative to the range of frequency variation.

Accordingly, even if, in the course of manufacturing, bodily-sensible vibration characteristics vary because of different points of resonance in individual multi-function vibrating actuator devices, or if points of resonance differ because of variations in the environments for use of terminal equipment in which the multi-function vibrating actuator devices are mounted, this embodiment blocks a sharp fall-off in the amount of bodily-sensible vibration, and prevents a situation in which the required amount of bodily-sensible vibration (greater than A0 [G] in FIG. **9**) cannot be obtained.

In this first embodiment, the outflow of air is restricted because the air within the device is used as a damper, but because the air passage holes **10a** through **10c** are opened in the side of the housing **1**, when the diaphragm **4** is vibrating the air within the space **S1** leaves the device through air passage holes **10a** through **10c**, and excessive expansion of the space **S1** is prevented. Accordingly, adverse effects on the vibration characteristics of the diaphragm during low-range sound production are prevented.

As described above, in devices that generate both sound and bodily-sensible vibrations, opening air passage holes **10a** through **10c** improves the stability and utility of bodily-sensible vibration characteristics without sacrificing acoustic characteristics; this is an extremely effective means.

<Second Embodiment>

In keeping with the demands of manufacturers of portable terminals, different characteristics and specifications are sometimes given to individual parts mounted in terminal equipment. For this reason, there are variations in the bodily-sensible vibration characteristics requested, and so there is no such thing as uniformly ideal bodily-sensible vibration characteristics. That being the case for multi-function vibrating actuator devices mounted in terminal equipment, it cannot be said that it is always best to make the clearance **G2** as small as possible as described for the first embodiment; it becomes necessary to make slight changes in the internal structure of the device in accordance with various demands.

In the second embodiment, in order to meet these demands, the size of the yoke **20** is changed in the facial direction (in the direction of the diameter of the round plate **20b**)**.** Specifically, the yoke is made variously within the range in which the interior air functions as a damper; that is, where the clearance measurement relative to the inner radius of the housing is more than 0% and not more than 2.5%, or more than 0 mm and not more than 0.2 mm, preferably at least 0.05 mm and not more than 0.15 mm. By adjusting and limiting the movement of interior air between spaces **S1** and **S2** in this way, it is possible to adjust the damping action that the air puts on the up and down vibration of the magnetic circuit.

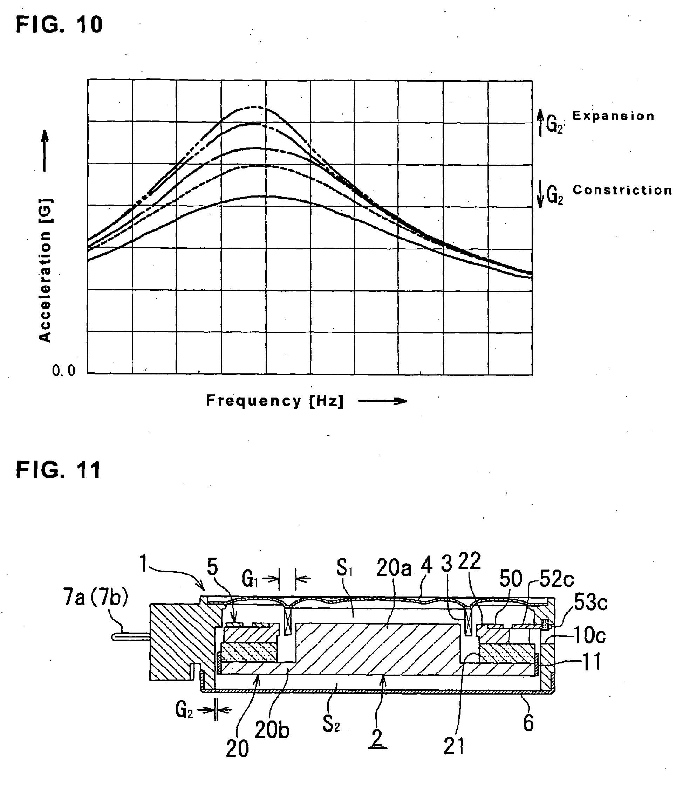

By enlarging the size of the clearance **G2**, it becomes possible to increase the acceleration as modeled in FIG. **10****.** By reducing the size of the clearance **G2,** on the other hand, it is possible to gently reduce the acceleration and expand the frequency range.

Now, in all the cases of vibration characteristics shown in FIG. **10****,** the same electrical signal is impressed on the voice coil, but the size of the clearance is varied. It is possible, however, to increase the acceleration by increasing the power of the electrical signal. Accordingly, by striking a balance between the desired amount of vibration and the size of the electrical signal impressed, it is possible to adjust the sharpness of the resonance, and design a setting of vibration characteristics that meets requirements.

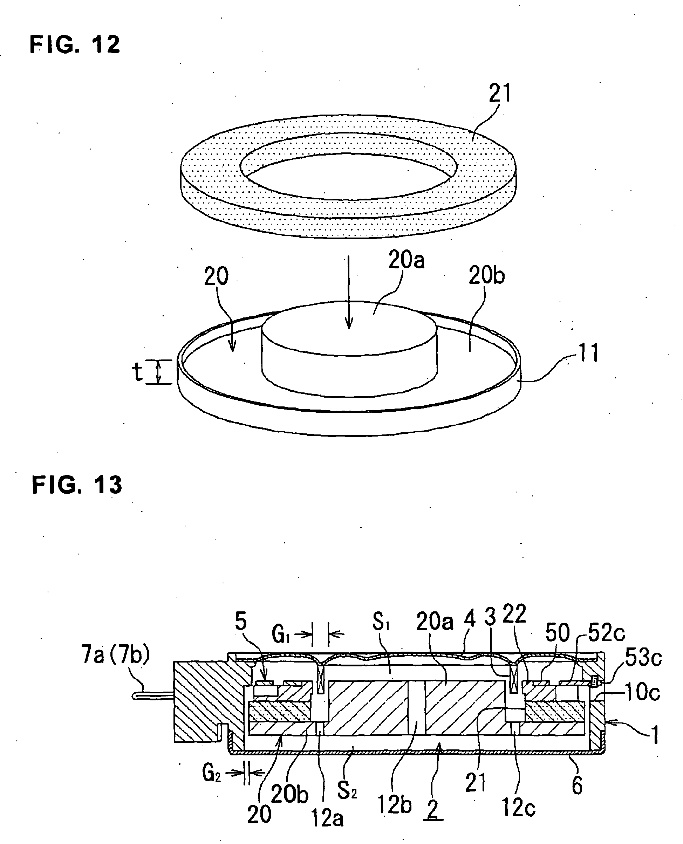

To manufacture the yoke **20** in different sizes depending on individual requirements, as described above, incurs production costs and the time and labor required for manufacture. For that reason, it is preferable to fit a ring **11** to the outer surface of the yoke **20,** as shown in FIGS. **11** and **12****,** in order to facilitate assembly and to reduce the production cost and time and labor of changing the clearance **G2.** In greater detail, the round plate **20b** is manufactured with a smaller radius than needed for the predetermined clearance size, and several patterns are prepared for rings of different sizes in the direction parallel to the diameter (the facial direction of ring 11).

By simply fitting this ring **11** around the outer surface of the ring plate **20b** of the yoke **20,** it is possible to freely change the size of the clearance **G2** between the outer surface of the magnetic circuit **2** and the inner surface of the housing **1.** The size of this ring **11** can be changed within a range such that the outer surface of the ring **11** will not contact the inner surface of the housing **1** when the magnetic circuit that comprises the yoke **20** to which the ring **11** is fitted vibrates up and down. Moreover, the thickness measurement **t** of the ring **11** is set to extend to the outer diameter of the magnet **21,** so that the prescribed air movement will depend on the inner diameter of the housing **1.**

By this means, the size of the yoke **20** can be set in a standard way, and so it is not necessary to produce the yoke **20** in different sizes. Further, the size of the inner periphery of the ring **11** is the same as the outside size of the yoke **20,** and so that need not be changed; the only thing to change is the outside size of the ring. Therefore, it is possible to freely vary the sharpness of resonance, the fall-off of acceleration and the width of the frequency band in coordination with the electrical signal, and at the same time to reduce production costs and the time and labor required for manufacture.

The ring **11** can be made of a polymer or other material that is non-magnetic and not subject to elastic deformation. If a ring subject to elastic deformation were fitted to the yoke, it would deform and be crushed if an external shock caused the outer surface of the ring to contact the inner surface of the housing. That would prevent further displacement of the yoke, and ultimately prevent enlargement of the displacement value of the magnetic circuit. It is thought that when the displacement value in the direction of the diameter is enlarged, the suspension that is fixed to the yoke twists and cannot return to its original shape, and becomes damaged.

It is also possible to change the structure by fixing the ring to the inner surface of the housing **1**, to form the clearance between the inner diameter of the ring and the round plate **20b.** In that event, the clearance can be changed by altering the measurement of the inner surface of the ring.

<Third Embodiment>

The third embodiment is constituted to set and change the bodily-sensible vibration characteristics by placing through holes **12a** through **12c** in the yoke **20,** as shown in FIG. **13****,** in addition to the air passage holes **10a** through **10c** and the clearance **G2** described above. The through holes **12a** through **12c** are bored through the yoke **20** in order to regulate and limit the amount of movement of interior air between spaces **S1** and **S2.**

The positions for piercing the through holes can be selected from both the pole piece **20a** and the round plate **20b,** as shown in the drawing, or either the pole piece **20a** or the round plate **20b**. The number of holes should be one or two, from the need to maintain the weight balance of the magnetic circuit, or that can be changed to three or six spaced at regular intervals around the periphery.

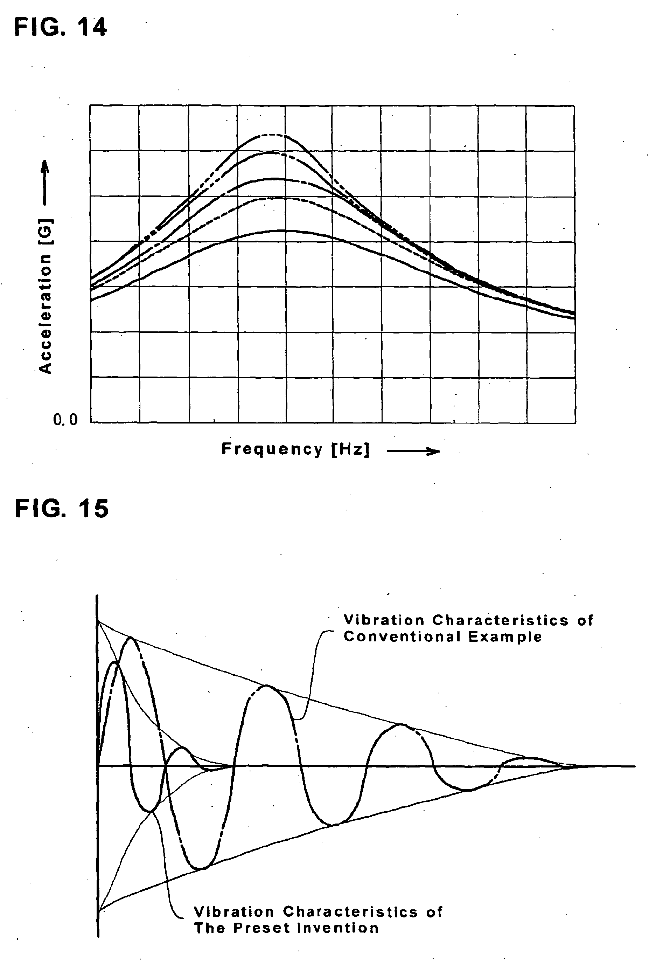

Assuming a fixed value for the power of the electrical signal impressed on the voice coil, it is possible to bring about different vibration characteristics depending on the number of through holes, as shown in FIG. **14****,** which shows the cases of no holes (solid curve), one hole (broken curve), two holes (one long/one short dash curve), three holes (one long/two short dash curve), and four holes (one long/three short dash curve).

As shown in FIG. **14****,** the vibration acceleration increases with the number and area of the through holes. That is, as the hole area increases, the movement of interior air between spaces **S1** and **S2** becomes easier, the air pressure from the interior air in the space **S1** is reduced, and its function as a damper is lessened. In consequence, the sharpness of resonance, the drop-off in acceleration, and the width of the frequency range can be made to vary in accordance with the number and area of the holes. In addition, it is possible to increase acceleration even if the power of the electrical signal impressed on the voice coil is large. Therefore, it is desirable to set the number and area of the holes in balance with the strength of the electrical signal.

In this third embodiment, changes in the bodily-sensible vibration characteristics are brought about by changing the number and area of through holes, within the range where the clearance **G2** has a damper function. Accordingly, it is not necessary to make the yoke in different sizes, not to produce an additional part like the ring in embodiment **2,** which enhances the stability and utility of the bodily-sensible vibration characteristics. Further, in comparison to the third embodiment, this embodiment enables easier changes of vibration characteristics, and it enables changes while holding down production costs and the time and labor required in manufacture.

<Principle of Reduction of Strange Noise>

If there is a blow to the outer case of the portable terminal equipment in which the multi-function vibrating actuator device is mounted, the vibration is transferred to the multi-function vibrating actuator device; the magnetic circuit will vibrate for some time and cause vibration of the air, which will produce a strange noise like a plucked bowstring. However, in all of the embodiments described above, the interior air within the device functions as a damper to block vibration of the magnetic circuit, and so vibration of the magnetic circuit is suppressed and quickly returns to normal.

When the multi-function vibrating actuator device involved in the first embodiment is mounted in a piece of portable terminal equipment and the vibration characteristics are measures through the outer case, the results are as shown by the solid curve in FIG. **15****.** It can be seen from this curve that the vibrations converge at zero more quickly than the conventional vibration characteristics represented by the long-and-short dash curve. Accordingly, the residual noise as heard by the ears of users of the portable terminal equipment is greatly reduced. Therefore, the users perception of the strange noise is reduced.

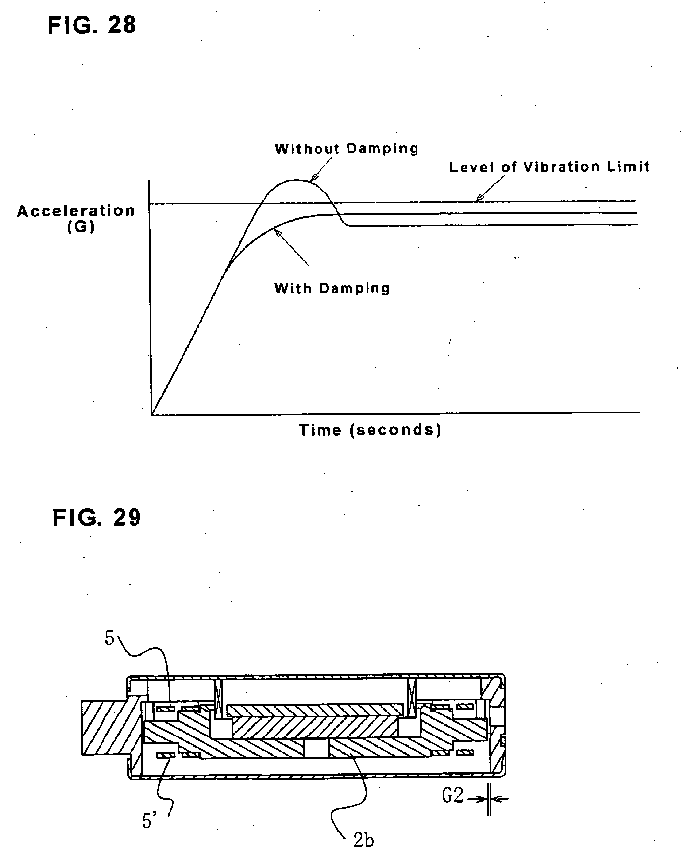

Further, the multi-function vibrating actuator of the present invention has improved vibration rise characteristics, as shown in FIG. **28****.** That is, in the case without damping (with no limitation of the movement of the air by the clearance **G2,** as in the conventional actuator), as represented by the broken curve, when the constant-state acceleration is set at a value close to the vibration threshold level, the acceleration exceeds the vibration threshold level before reaching the constant state; this produces a strange sound. By contrast, in the case with damping (with limitation of the movement of the air by the clearance **G2,** as in the actuator of the present invention), as represented by the solid curve, the rise characteristics are stable. Further, because the amplitude is attenuated more quickly, acceleration does not exceed the vibration threshold level. Therefore, the occurrence of strange noises can be prevented.

<Other Embodiments>

The embodiments described above have been explained as the first and second embodiments that have air passage holes **10a** through **10c** opened in the side of the housing **1** and the third embodiment that has through holes **12a** through **12c** in the yoke **20,** in addition to air passage holes **10a** through **10c**. Beside these embodiments, it is also possible to constitute this multi-function vibrating actuator device with air passage holes **13a**, **13b** etc. in the cover **6** and no holes in the housing **1.** It is also possible to constitute the invention by putting air passage holes (not illustrated) in the diaphragm, within a range that does not alter the vibration characteristics.

<Alternative Forms>

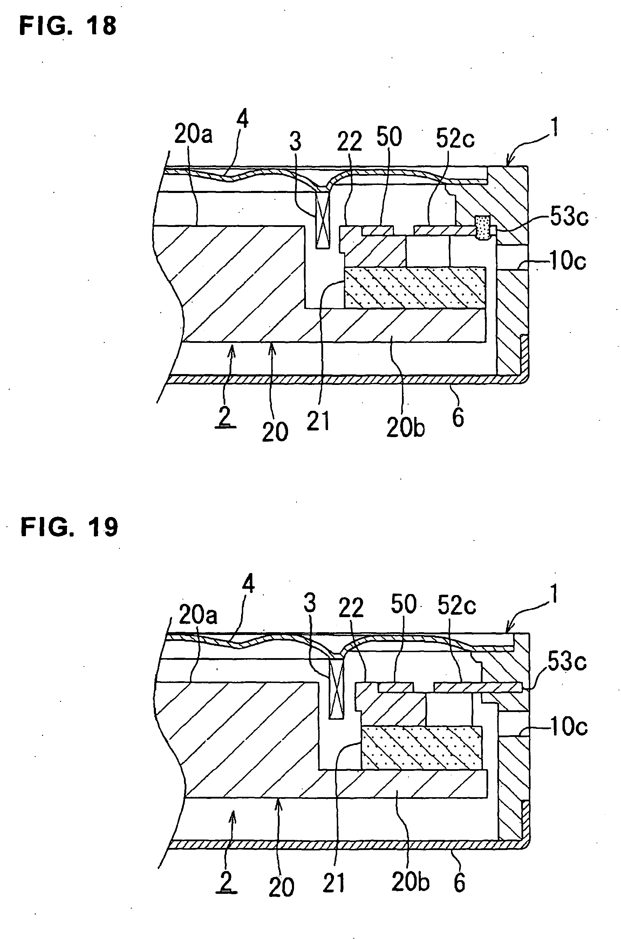

The embodiments described above were explained on the basis of the attachment blades **53a** through **53c** of the spring arms **52a** through **52c** of the suspension **5** being fixed into the air passage holes **10a** through **10c** in the housing **1.** Aside from that, it is possible to have an alternate constitution with a shelf in the inside of the housing **1,** as shown in FIG. **18****,** to which the attachment blades **53a** through **53c** are fastened as a way of holding the suspension **5** and the magnetic circuit **2** within the housing **1.**

It is also possible to hold the suspension **5** within the housing **1** as shown in FIG. **19****,** by having the spring arms **52c** (only one illustrated) of the suspension **5** form an insert that is a single unit with the housing **1.** But using a constitution of this sort, the holding strength of the suspension **5** can be increased, and with the increase in its holding strength the magnetic circuit **2** is held more firmly within the housing **1,** so that the resonant frequency of the magnetic circuit **2** is maintained stable, with no scattering. This is preferable to the examples of implementation shown above.

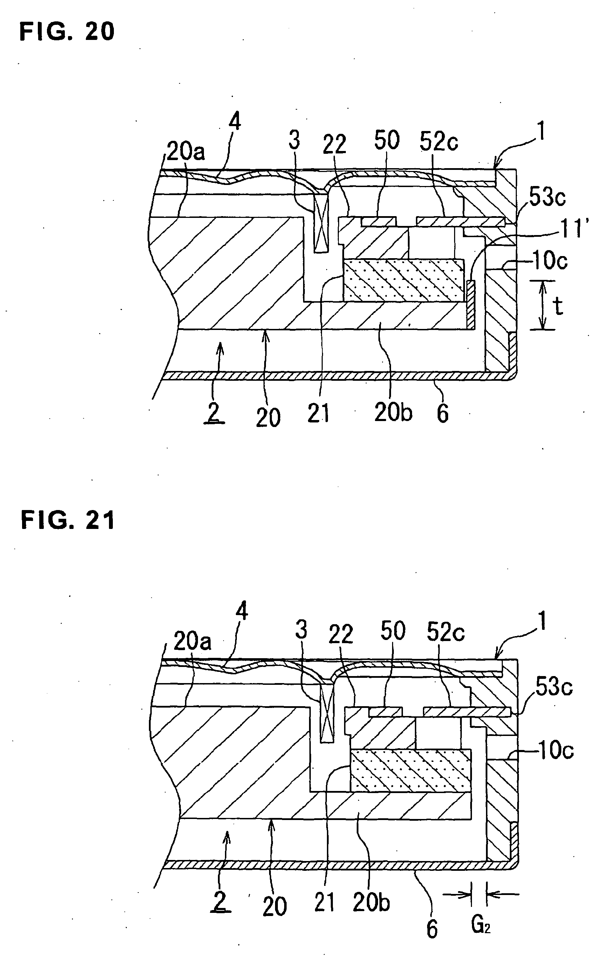

In the alternative form shown in FIG. **19****,** the magnet **21** is formed slightly smaller than the outside diameter of the yoke **20,** so that there is no danger of contacting the inner rim of the housing **1** when the magnet **21** is at top dead center during vibration. In this case, when a ring **11** is fitted over the outer surface of the yoke **20,** it is desirable from the perspective of convenience of the damper function to use a ring **11'** that has a thickness measurement **t** that covers the outer surface of the magnet **21.** Further, it is desirable that the yoke **20** and the magnet **21** have the same outside diameter, as shown in FIG. **21****,** as long as it is possible to set the measurement of the clearance **G2** at more than 0% and not more than 2.5% of the inside diameter of the housing **1,** or more than 0 mm and not more than 0.2 mm, preferably at least 0.05 mm and not more than 0.15 mm.

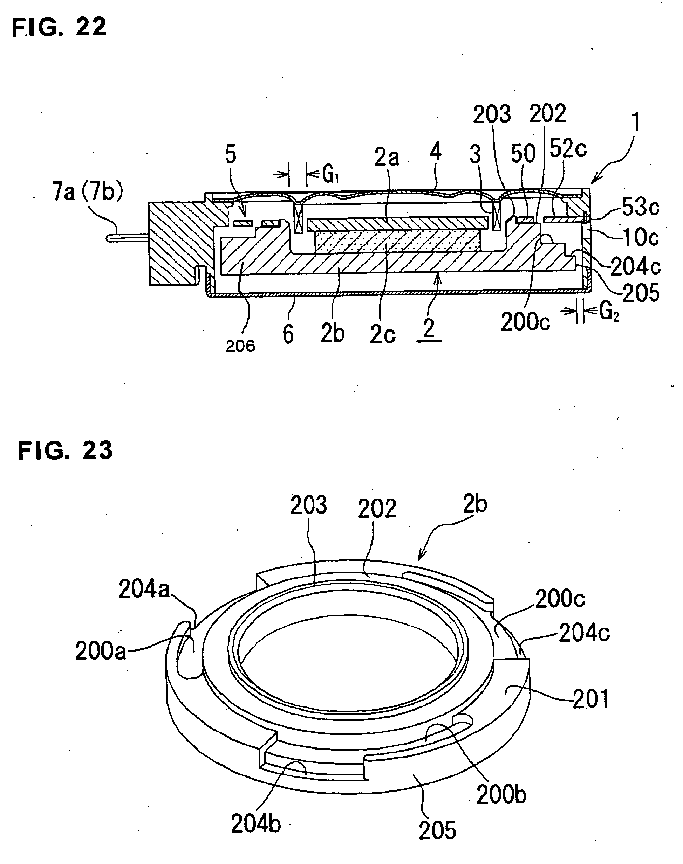

The modes described above are explained on the basis of a multi-function vibrating actuator device of the outer-magnet type, but the invention is also appropriate to the constitution of a multi-function vibrating actuator device as in FIG. **22****,** with an inner-magnet type of magnetic circuit **2** formed by fastening a pole piece **2a** and yoke **2b** to the magnet **2c** so as to create a gap **G1** that functions as the magnetic gap. The outer surface of the yoke **2b** should be in close proximity to the inner surface if the housing **1,** so that the clearance **G2** is set at more than 0% and not more than 2.5% of the inside diameter of the housing **1,** or more than 0 mm and not more than 0.2 mm, preferably at least 0.05 mm and not more than 0.15 mm.

In the case of this inner-magnet type to magnetic circuit **2,** the yoke **2b** has a stepped surface **201,** as shown in FIG. **23****,** in which recessed run-offs **200a** through **200c** face the spring arms of the suspension **5** so that there is no contact with the spring arms when the spring arms of the suspension flex in the course of bodily-sensible vibration. This stepped surface **201** steps down from the upper surface **202** to which the ring portion of the suspension is fixed. A retaining ring **203** with an outside diameter that fits into ring portion of the suspension rises from the upper surface **202** of the yoke **2b.**

In addition, recessed run-offs **204a** through **204c** are notched into the outer rim to open the sides of the recessed run-offs **200a** through **200c.** In the event that a shelf is recessed into the inner wall of the housing and the attachment blades of the spring arms of the suspension are fixed to the shelf, these are recessed into the outer rim of the yoke **2b** to prevent contact with the projecting edge of the shelf.

Now, in this embodiment the movable parts are the magnetic circuit **2** that comprises the pole piece **2a,** the yoke **2b,** and the magnet **2c,** and also a projection **206** that is formed as a single unit in the radial direction of the yoke **2b.**

The terms and expressions used above in this specification are simply for the purpose of explanation. Accordingly, although the embodiments described above were explained as having a single suspension, the invention is also appropriate to a type with two suspensions **5, 5',** like the multi-function vibrating actuator device shown in FIG. **29****.** That is, in the case of the multi-function vibrating actuator device shown in FIG. **29****,** the close approach of the side of the yoke **2b** to the inside of the housing creates a clearance **G2** that limits the amount of air movement.

Further, the embodiments described above were explained with examples of outer-magnet type of multi-function vibrating actuators and inner-magnet type of multi-function vibrating actuators, but the invention is not limited to these types. Accordingly, although they are not illustrated, the invention is also appropriate to radial-allocation type multi-function vibrating actuator devices. That is, by having the side of the moving part or the magnetic circuit of a radial-allocation type multi-function vibrating actuator device closely approach the inside of the housing, it is possible to form a clearance that limits the movement of air. Further, the structure of the magnetic circuit or moving part is not limited to the structure explained in the modes described above.

Moreover, the embodiments described above were explained using as an example the type of housing in which both ends are open and a cover is placed on the open end opposite the diaphragm, but the present invention is not limited by that; it is also possible for the housing to be formed as a tube with a closed bottom.

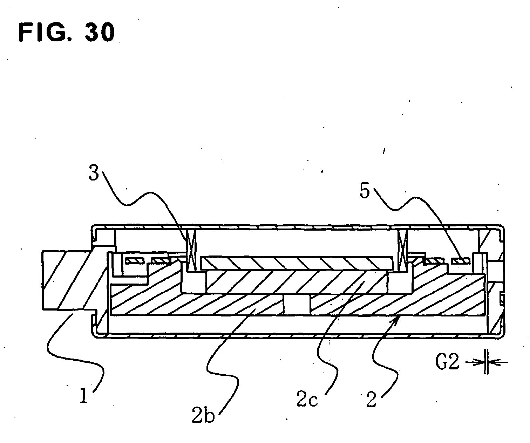

Further, the embodiments described above were explained with examples of multi-function vibrating actuator devices that have generative functions such as ring tones, but the present invention is not limited to these multi-function vibrating actuator devices; it can be applied to a vibrating actuator as shown in FIG. **30**.

### INDUSTRIAL APPLICABILITY

As stated above, according to the multi-function vibrating actuator device of claims 1 through 5 of the present invention, it is possible to expand the frequency range that yields the bodily-sensible vibrations required for notification of incoming calls, by using the interior air of the device as a damper to block the up and down vibrating motion of the magnetic circuit. This makes it possible to obtain the acceleration required for bodily-sensible vibrations over a broader range of frequencies, and so it is easy to set the point of resonance without the point of resonance drifting out of the frequency range. Therefore, it is easier to obtain the desired frequency acceleration, and so the stability and utility of bodily-sensible vibration characteristics is improved.

In addition to that, it is possible to ease the drop-off of acceleration relative to the amplitude of changes of frequency. Because of that, it is possible to prevent a sharp drop-off of bodily-sensible vibrations when slippage of the point of resonance in individual devices occurs during manufacture and causes scattering of the bodily-sensible vibration characteristics, or when there is resonance point slippage because of variation in the environments for use of the portable terminals in which the multi-function vibrating actuator devices are mounted. It is thus possible to prevent the occurrence of situations in which the required amount of bodily-sensible vibrations is not obtained.

Further, by using the air within the device as a damper, as described above, and blocking the up and down vibrating motion of the magnetic circuit by means of that damper action, it is possible to reduce strange sounds when the portable terminal equipment is in the state of awaiting incoming calls. Moreover, by changing the size of the diameter of the magnetic circuit, it is possible to change the bodily-sensible vibration characteristics in accordance with the demands of individual producers of portable terminal equipment.

According to the multi-function vibrating actuator device of claim 3 of the present invention, it is possible to change the vibration characteristics of the magnetic circuit by putting through holes in the magnetic circuit, and thus to easily assemble the device according to individual demands, and to change bodily-sensible vibration characteristics while suppressing production costs and the time and labor used in manufacture.

According to the multi-function vibrating actuator device of claim 4 of the present invention, it is possible to fit a ring of matching shape to the outer surface of the magnetic circuit and to adjust the clearance between the outside of the ring and the inside surface of the housing by means of the size of the ring in the facial direction. Because of that, the multi-function vibrating actuator device can be assembled more easily in accordance with the demands of the manufacturer, and it is possible to freely vary the sharpness of resonance, drop-off of acceleration, and the width of the frequency range while suppressing production costs and the time and labor used in manufacture.

The multi-function vibrating actuator device or vibrating actuator device of the present invention applies a damper to the magnetic circuit or moving part by using the air resistance when the interior air passes through the clearance. Because the clearance is greater than 0 mm but not greater than 0.2 mm, air resistance is created, and so the rise characteristics and fall characteristics of the multi-function vibrating actuator device or vibrating actuator device are smoothed out, and control of vibration becomes easier. Further, it is possible to expand the width of the frequency range that yields the bodily-sensible vibrations necessary for incoming call notification. Because of that, the acceleration needed for bodily-sensible vibrations can be obtained over a broader range of frequencies, and so it is easier to set the point of resonance without the point of resonance drifting from the frequency range. It is therefore easier to obtain the required vibration acceleration, and the stability and utility of bodily-sensible vibration characteristics can be improved.

### DESCRIPTION OF REFERENCE NUMERALS

- **1**: Housing
- **2**: Magnetic Circuit
- **20**: Yoke
- **20a**: Pole Piece
- **20b**: Round Plate
- **21**: Magnet
- **22**: Yoke Plate
- **3**: Voice Coil
- **4**: Diaphragm
- **5**: Suspension
- **52a - 52c**: Suspension Spring Arms
- **6**: Cover
- **G1**: Magnetic Gap
- **G2**: Clearance
- **S1, S2**: Air Space Within Device
- **10a - 10c**: Air Holes In Housing
- **11**: Ring fitted to yoke
- **12a - 12c**: Through Holes In Magnetic Circuit
- **13a, 13b**: Air Holes In Cover

## Claims

1. A multi-function vibrating actuator device, in which there are provided
an outer-magnet type of magnetic circuit (2) including a discal yoke (20) with a pole piece (20a) at a center thereof, a yoke plate (22) and a ring magnet (21) as a single unit, forming a gap that functions as a magnetic gap between an outer face of the pole piece (20a) and respective inner faces of the magnet (21) and yoke plate (22), a diaphragm (4) fastened to an top of a voice coil (3),
a suspension (5) including a plurality of spring arms that extend along an outer periphery thereof from a support portion for supporting the magnetic circuit (2),
a substantially cylindrical housing (1) that is open on both ends thereof, and a cover (6),
the magnetic circuit (2) being supported within the housing (1) by the suspension (5), tips of the spring arms of which are attached to the sides of the housing (1),
the voice coil (3) being located within the magnet gap,
the opening at one end of the housing (1) being covered by the diaphragm (4) with an outer edge of the diaphragm (4) being attached to a rim of the opening of the housing (1)
and the opening at the other end of the housing (1) being covered by the cover (6) with an outer edge of the cover (6) being attached to a rim of the opening of the housing (1),
and the magnetic circuit (2) being made vibrate within the housing (1) by an electrical signal being applied to the voice coil (3),
wherein an air passage hole (10c) is formed at least at one part among said housing (1), cover (6) and diaphragm (4),
**characterized in that** the amount of movement of interior air in a space formed by said diaphragm (4) and said magnetic circuit (2) and of interior air in a space formed by said magnetic circuit (2) and said cover (6) is restricted by a clearance so as to expand a range of frequencies at which said magnetic circuit (2) is able to vibrate, and
wherein
a) said magnetic circuit (2) is assembled with an outer surface thereof in close proximity to an inner surface of the housing (1) so as to create said clearance between an outer surface of the magnetic circuit (2) and an inner surface of the housing (1) that measures more than 0% and not more than 2.5% of the inside radius of the housing (1), or
b) a ring (11) is fitted around an outer periphery of said magnetic circuit (2) so as to create said clearance between an outer surface of the ring (11) and an inner surface of the housing (1) that measures more than 0% and not more than 2.5% of the inside radius of the housing (1).

2. The multi-function vibrating actuator device of claim 1, wherein said yoke plate (22) includes a ring with brim projections at an outer periphery of the ring in accordance with the number of spring arms, the brim projections being arranged so as not to overlap points of attachment between said housing (1) and suspension (5).

3. The multi-function vibrating actuator device of claim 1 or 2, wherein a through hole is formed in said magnetic circuit (2).

4. A multi-function vibrating actuator device, in which there are provided an inner-magnet type of magnetic circuit (2)
in which a pole piece (2a) and a yoke (2b) are fixed to a magnet (2c) as a single unit, forming a gap that functions as a magnetic gap,
a diaphragm (4) fastened to an top of a voice coil (3),
a suspension (5) including a plurality of spring arms that extend along an outer periphery thereof from a support portion for supporting the magnetic circuit (2),
a substantially cylindrical housing (1) that is open on both ends thereof,
and a cover (6),
the magnetic circuit (2) being supported within the housing (1) by the suspension (5), tips of the spring arms of which are attached to the sides of the housing (1),
the voice coil (3) being located within the magnet gap,
the opening at one end of the housing (1) being covered by the diaphragm (4) with an outer edge of the diaphragm (4) being attached to a rim of the opening of the housing (1)
and the opening at the other end of the housing (1) being covered by the cover (6) with an outer edge of the cover (6) being attached to a rim of the opening of the housing (1), and the magnetic circuit (2) being made vibrate within the housing (1) by an electrical signal being applied to the voice coil (3),
wherein an air passage hole (10c) is formed at least at one part among said housing (1), cover (6) and diaphragm (4), **characterized in that**
said magnetic circuit (2) is assembled with an outer surface thereof in close proximity to an inner surface of the housing (1) so as to create a clearance between an outer surface of the magnetic circuit (2) and an inner surface of the housing (1) that measures more than 0% and not more than 2.5% of the inside radius of the housing (1),
and the amount of movement of interior air in a space formed by said diaphragm (4) and said magnetic circuit (2) and of interior air in a space formed by said magnetic circuit (2) and said cover (6) is restricted by said clearance so as to expand a range of frequencies at which said magnetic circuit (2) is able to vibrate.

## Patentansprüche

1. Multifunktionsvibrationsstellantriebsvorrichtung, bei der
ein Magnetkreis (2) in Außenmagnetausführung, der ein scheibenförmiges Joch (20) mit einem Polschuh (20a) in dessen Mitte, eine Jochplatte (22) und einen Ringmagneten (21) als einzelne Baugruppe aufweist, die einen Spalt bildet, der als Magnetspalt zwischen einer Außenfläche des Polschuhs (20a) und jeweiligen Innenflächen des Magneten (21) und der Jochplatte (22) wirkt, eine an einer Oberseite einer Schwingspule (3) befestigte Membran (4),
eine Aufhängung (5), die mehrere Federarme aufweist, die sich entlang einem Außenumfang der Aufhängung von einem Lagerabschnitt zur Lagerung des Magnetkreises (2) aus erstrecken,
ein im wesentlichen zylindrisches Gehäuse (1), das an seinen beiden Enden offen ist, sowie eine Abdeckung (6) vorgesehen sind,
wobei der Magnetkreis (2) von der Aufhängung (5) im Gehäuse (1) gelagert ist, wobei deren Federarme mit Spitzen an den Seiten des Gehäuses (1) befestigt sind,
wobei sich die Schwingspule (3) in dem Magnetspalt befindet,
wobei die Öffnung an einem Ende des Gehäuses (1) von der Membran (4) abgedeckt ist, wobei ein Außenrand der Membran (4) an einem Rand der Öffnung des Gehäuses (1) befestigt ist
und die Öffnung am anderen Ende des Gehäuses (1) von der Abdeckung (6) abgedeckt ist, wobei ein Außenrand der Abdeckung (6) an einem Rand der Öffnung des Gehäuses (1) befestigt ist
und wobei der Magnetkreis (2) durch ein an die Schwingspule (3) angelegtes elektrisches Signal in dem Gehäuse (1) zum Schwingen gebracht wird,
wobei an dem Gehäuse (1) und/oder an der Abdeckung (6) und/oder an der Membran (4) eine Luftdurchgangsbohrung (10c) gebildet ist,
**dadurch gekennzeichnet, dass** das Maß an Bewegung von Innenluft in einem von der Membran (4) und dem Magnetkreis (2) gebildeten Raum und von Innenluft in einem von dem Magnetkreis (2) und der Abdeckung (6) gebildeten Raum durch einen Zwischenraum eingeschränkt ist, um einen Bereich von Frequenzen zu erweitern, bei denen der Magnetkreis (2) schwingen kann, und
wobei
a) der Magnetkreis (2) so zusammengesetzt ist, dass eine Außenoberfläche des Magnetkreises so in unmittelbarer Nähe zu einer Innenoberfläche des Gehäuses (1) gelegen ist, dass der Zwischenraum zwischen einer Außenoberfläche des Magnetkreises (2) und einer Innenoberfläche des Gehäuses (1) geschaffen ist, der mehr als 0% und nicht mehr als 2.5% des Innenradius des Gehäuses (1) misst, oder
b) ein Ring (11) so um einen Außenumfang des Magnetkreises (2) angebracht ist, dass der Zwischenraum zwischen einer Außenoberfläche des Ringes (11) und einer Innenoberfläche des Gehäuses (1) geschaffen ist, der mehr als 0% und nicht mehr als 2.5% des Innenradius des Gehäuses (1) misst.

2. Multifunktionsvibrationsstellantriebsvorrichtung nach Anspruch 1, bei der die Jochplatte (22) einen Ring mit Randvorsprüngen an einem Außenumfang des Ringes entsprechend der Anzahl der Federarme aufweist, wobei die Randvorsprünge so angeordnet sind, dass sie Befestigungspunkte zwischen dem Gehäuse (1) und der Aufhängung (5) nicht überlappen.

3. Multifunktionsvibrationsstellantriebsvorrichtung nach Anspruch 1 oder 2, bei der in dem Magnetkreis (2) ein Durchgangsloch gebildet ist.

4. Multifunktionsvibrationsstellantriebsvorrichtung, bei der ein Magnetkreis (2) in Innenmagnetausführung,
bei dem ein Polschuh (2a) und ein Joch (2b) an einem Magneten (2c) als einzelne Baugruppe angebracht sind, die einen Spalt bildet, der als Magnetspalt wirkt,
eine an einer Oberseite einer Schwingspule (3) befestigte Membran (4),
eine Aufhängung (5), die mehrere Federarme aufweist, die sich entlang einem Außenumfang der Aufhängung von einem Lagerabschnitt zur Lagerung des Magnetkreises (2) aus erstrecken,
ein im wesentlichen zylindrisches Gehäuse (1), das an seinen beiden Enden offen ist,
sowie eine Abdeckung (6) vorgesehen sind,
wobei der Magnetkreis (2) von der Aufhängung (5) im Gehäuse (1) gelagert ist, wobei deren Federarme mit Spitzen an den Seiten des Gehäuses (1) befestigt sind,
wobei sich die Schwingspule (3) in dem Magnetspalt befindet,
wobei die Öffnung an einem Ende des Gehäuses (1) von der Membran (4) abgedeckt ist, wobei ein Außenrand der Membran (4) an einem Rand der Öffnung des Gehäuses (1) befestigt ist
und die Öffnung am anderen Ende des Gehäuses (1) von der Abdeckung (6) abgedeckt ist, wobei ein Außenrand der Abdeckung (6) an einem Rand der Öffnung des Gehäuses (1) befestigt ist und der Magnetkreis (2) durch ein an die Schwingspule (3) angelegtes elektrisches Signal in dem Gehäuse (1) zum Schwingen gebracht wird,
wobei an dem Gehäuse (1) und/oder an der Abdeckung (6) und/oder an der Membran (4) eine Luftdurchgangsbohrung (10c) gebildet ist, **dadurch gekennzeichnet, dass**
der Magnetkreis (2) so zusammengesetzt ist, dass eine Außenoberfläche des Magnetkreises so in unmittelbarer Nähe zu einer Innenoberfläche des Gehäuses (1) gelegen ist, dass ein Zwischenraum zwischen einer Außenoberfläche des Magnetkreises (2) und einer Innenoberfläche des Gehäuses (1) geschaffen ist, der mehr als 0% und nicht mehr als 2.5% des Innenradius des Gehäuses (1) misst,
und das Maß an Bewegung von Innenluft in einem von der Membran (4) und dem Magnetkreis (2) gebildeten Raum und von Innenluft in einem von dem Magnetkreis (2) und der Abdeckung (6) gebildeten Raum durch den Zwischenraum eingeschränkt ist, um einen Bereich von Frequenzen zu erweitern, bei denen der Magnetkreis (2) schwingen kann.

## Revendications

1. Dispositif actionneur vibrant multifonction, dans lequel il est prévu un circuit magnétique (2) du type à aimant externe, présentant une culasse (20) en forme de disque avec une pièce polaire (20a) au centre de celle-ci, une plaque de culasse (22) et un aimant annulaire (21) sous forme d'ensemble individuel formant un entrefer qui agit en tant qu'entrefer magnétique entre une face extérieure de la pièce polaire (20a) et des faces intérieures respectives de l'aimant (21) et de la plaque de culasse (22), un diaphragme (4) fixé sur une partie supérieure d'une bobine mobile (3),
une suspension (5) présentant une pluralité de bras à ressort s'étendant le long d'une périphérie extérieure de celle-ci à partir d'un tronçon de support pour le support du circuit magnétique (2),
un boîtier (1) sensiblement cylindrique qui est ouvert à ses deux extrémités, et un recouvrement (6),
le circuit magnétique (2) étant supporté à l'intérieur du boîtier (1) par la suspension (5), des extrémités des bras de ressort de celle-ci étant fixées sur les côtés du boîtier (1),
la bobine mobile (3) étant agencée à l'intérieur de l'entrefer magnétique, l'orifice à une extrémité du boîtier (1) étant recouvert par le diaphragme (4), une arête extérieure du diaphragme (4) étant fixée à un bord de l'orifice du boîtier (1).
et l'orifice à l'autre extrémité du boîtier (1) étant recouvert par le recouvrement (6), une arête extérieure du recouvrement (6) étant fixée à un bord de l'orifice du boîtier (1),
et le circuit magnétique (2) étant amené à vibrer à l'intérieur du boîtier (1) au moyen d'un signal électrique appliqué à la bobine mobile (3),
un trou de passage d'air (10c) étant réalisé sur le boîtier (1) et/ou le recouvrement (6) et/ou le diaphragme (4),
**caractérisé en ce que** l'étendue du mouvement d'air intérieur dans un espace formé par le diaphragme (4) et le circuit magnétique (2) et d'air intérieur dans un espace formé par le circuit magnétique (2) et le recouvrement (6) étant réduite par un espacement de manière à élargir une gamme de fréquence dans laquelle le circuit magnétique (2) est apte à vibrer, et
dans lequel
a) le circuit magnétique (2) est assemblé de telle sorte qu'une surface extérieure de celui-ci se trouve à proximité immédiate d'une surface intérieure du boîtier (1) de manière à former l'espacement entre une surface extérieure du circuit magnétique (2) et une surface intérieure du boîtier (1) qui mesure plus de 0 % et pas plus de 2,5 % du rayon intérieur du boîtier (1), ou
b) un anneau (11) est agencé autour d'une périphérie extérieure du circuit magnétique (2) de manière à former l'espacement entre une surface extérieure de l'anneau (11) et une surface intérieure du boîtier (1) qui mesure plus de 0 % et pas plus de 2,5 % du rayon intérieur du boîtier (1).

2. Dispositif actionneur vibrant multifonction selon la revendication 1, dans lequel la plaque de culasse (22) présente un anneau qui comporte des saillies de bord à une périphérie extérieure de l'anneau correspondant au nombre de bras à ressort, les saillies de bord étant agencées de manière à ne pas recouvrir des points de fixation entre le boîtier (1) et la suspension (5).

3. Dispositif actionneur vibrant multifonction selon la revendication 1 ou 2, dans lequel un trou de passage est réalisé dans le circuit magnétique (2).

4. Dispositif actionneur vibrant multifonction, dans lequel il est prévu un circuit magnétique (2) du type à aimant interne,
dans lequel une pièce polaire (2a) et une culasse (2b) sont fixées à un aimant (2c) sous forme d'ensemble individuel formant un entrefer qui agit en tant qu'entrefer magnétique,
un diaphragme (4) fixé à une partie supérieure d'une bobine mobile (3),
une suspension (5) présentant une pluralité de bras à ressort qui s'étendent le long d'une périphérie extérieure de celle-ci à partir d'un tronçon de support pour le support du circuit magnétique (2),
un boîtier (1) sensiblement cylindrique qui est ouvert à ses deux extrémités, et un recouvrement (6),
le circuit magnétique (2) étant supporté à l'intérieur du boîtier (1) par la suspension (5), des extrémités des bras de ressort de celle-ci étant fixées sur les côtés du boîtier (1),
la bobine mobile (3) étant agencée à l'intérieur de l'entrefer magnétique, l'orifice à une extrémité du boîtier (1) étant recouvert par le diaphragme (4), une arête extérieure du diaphragme (4) étant fixée à un bord de l'orifice du boîtier (1),
et l'orifice à l'autre extrémité du boîtier (1) étant recouvert par le recouvrement (6), une arête extérieure du recouvrement (6) étant fixée à un bord de l'orifice du boîtier (1), et le circuit magnétique (2) étant amené à vibrer à l'intérieur du boîtier (1) au moyen d'un signal électrique appliqué à la bobine mobile (3),
un trou de passage d'air (10c) étant réalisé sur le boîtier (1) et/ou le recouvrement (6) et/ou le diaphragme (4), **caractérisé en ce que**
le circuit magnétique (2) est assemblé de telle sorte qu'une surface extérieure de celui-ci se trouve à proximité immédiate d'une surface intérieure du boîtier (1) de manière à former un espacement entre une surface extérieure du circuit magnétique (2) et une surface intérieure du boîtier (1) qui mesure plus de 0 % et pas plus de 2,5 % du rayon intérieur du boîtier (1),
et **en ce que** l'étendue du mouvement d'air intérieur dans un espace formé par le diaphragme (4) et le circuit magnétique (2) et d'air intérieur dans un espace formé par le circuit magnétique (2) et le recouvrement (6) est réduite par un espacement de manière à élargir une gamme de fréquence dans laquelle le circuit magnétique (2) est apte à vibrer.
